# EUROPEAN PATENT SPECIFICATION

(11) **EP 4 398 429 B1**
(45) Date of publication and mention of the grant of the patent: **30.09.2026**
(21) Application number: 23217092.8
(22) Date of filing: 15.12.2023
(51) Int. Cl.: H01S 5/30, H01S 5/42, H01S 5/065, H01S 5/183, H01S 5/40

(54) **RED-GREEN-BLUE, VERTICAL-CAVITY, SURFACE-EMITTING LASER ARRAY**
ROT-GRÜN-BLAUE OBERFLÄCHENEMITTIERENDE LASERANORDNUNG MIT VERTIKALEM RESONATOR
RÉSEAU LASER À CAVITÉ VERTICALE ÉMETTANT PAR LA SURFACE, ROUGE-VERT-BLEU

(30) Priority: 16.12.2022 US 202263433147 P; 06.12.2023 US 202318530296
(43) Date of publication of application: 10.07.2024
(73) Proprietor: II-VI Delaware, Inc., Wilmington, DE 19890 (US)
(72) Inventor: BARBAROSSA, Giovanni, Wilmington, 19890 (US); LICHTENSTEIN, Norbert, Wilmington, 19890 (US); ENG, Julie, Wilmington, 19890 (US); KOCOT, Christopher, Wilmington, 19890 (US); TATARCZAK, Anna, Wilmington, 19890 (US); SCHIATTONE, Francesco, Wilmington, 19890 (US); TAN, Jason Lin-Chew, Wilmington, 19890 (US)
(74) Representative: Schmidt, Christian

(56) References cited:
- US-A1- 2021 305 784
- US-B2- 10 971 890

## Description

### CROSS-REFERENCE TO RELATED APPLICATIONS

This application claims the benefit of and priority to U.S. Provisional Patent Application Ser. No. 63/433,147, titled RED-GREEN-BLUE, VERTICAL-CAVITY, SURFACE-EMITTING LASER ARRAY, filed Dec. 16, 2022.

### BACKGROUND

Limitations and disadvantages of VCSEL arrays will become apparent to one of skill in the art, through comparison of such approaches with some aspects of the present method and system set forth in the remainder of this disclosure with reference to the drawings. Patent Application US 2021/0305784 A1 discloses an image acquiring device for easily acquiring a hyper spectral image in a small device and enhancing wavelength resolution. The light source portion of the device includes an emitter portion having a plurality of groups of emitters configured to emit light of different wavelengths, a circuit portion dividing the emitter portion into a plurality of segments and configured to control the plurality of segments independently.

### BRIEF SUMMARY

Systems and methods are provided for producing an RGB VCSEL array, substantially as illustrated by and/or described in connection with at least one of the figures, as set forth more completely in the claims.

### BRIEF DESCRIPTION OF THE DRAWINGS

FIG. 1 illustrates example embodiments of the disclosure comprising 2D RGB VCSEL arrays, in accordance with various example implementations of this disclosure.
FIG. 2 illustrates an example embodiment of the disclosure comprising active regions and tunnel junctions between Distributed Bragg Reflector (DBR) mirror stacks, in accordance with various example implementations of this disclosure.
FIGs. 3a-c illustrate example embodiments of the disclosure comprising active regions between DBR mirror stacks, in accordance with various example implementations of this disclosure.
FIGs. 4a-b illustrate example embodiments of the disclosure comprising RGB VCSEL arrays for an AR application, in accordance with various example implementations of this disclosure.
FIGs. 5 and 6 illustrate example embodiments of micro optics on a wafer, in accordance with various example implementations of this disclosure.
FIGs. 7a-c illustrates an example embodiment of the disclosure comprising a VCSEL without a lens, in accordance with various example implementations of this disclosure.
FIGs. 8a-c illustrates an example embodiment of the disclosure comprising a VCSEL with a collimator, in accordance with various example implementations of this disclosure.
FIGs. 9a-c illustrates an example embodiment of the disclosure comprising a VCSEL with a diffuser, in accordance with various example implementations of this disclosure.

### DETAILED DESCRIPTION

This disclosure describes a composite array of vertical-cavity surface-emitting lasers (VCSELs), including discrete VCSELs emitting at one wavelength of a group of wavelengths greater than two, each wavelength of said group of wavelengths being in the blue range (i.e., 440 to 495 nm), the green range (i.e., 495 to 580 nm) or the red range (i.e., 610 to 760 nm).

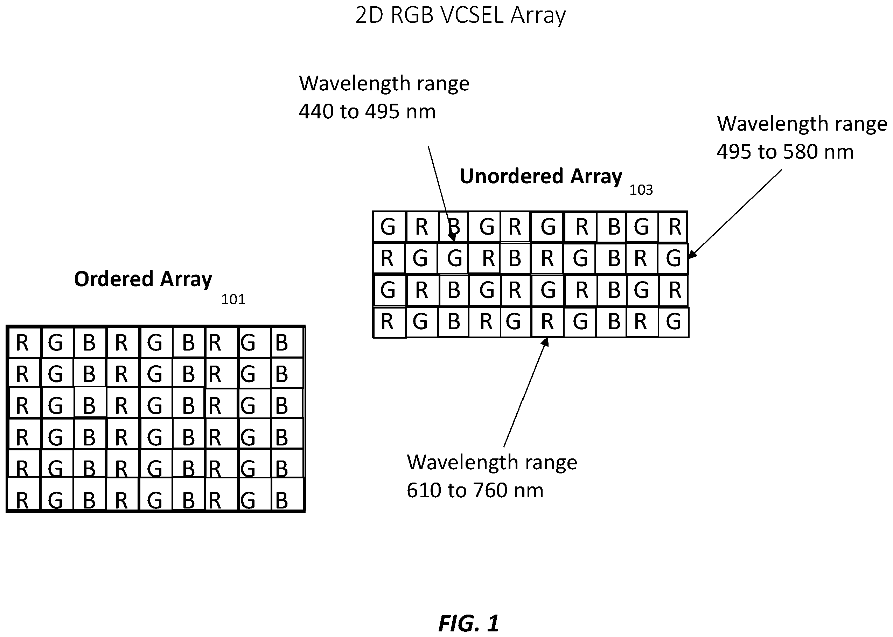

FIG. 1 illustrates example embodiments of the disclosure comprising 2D RGB VCSEL arrays, in accordance with various example implementations of this disclosure.

As an example of the implementation, discrete VCSELs are used in each wavelength range and are mounted together on a chip to form a 1D or a 2D array. GaN-based VCSELs with an InGaN active region may be used with dielectric mirrors for the blue and green ranges. VCSELs with an (AlGa)InP active region and an AlGaAs N and P Distributed Bragg Reflector (DBR) mirror stacks grown on a GaAs substrate may be used for red range.

The arrays can be ordered 101 or unordered 103. The composite arrays can be addressable by row, by column or at individual VCSEL level. The arrays 101, 103 may be biased in a common cathode or a common anode configuration.

The arrays 101, 103 may have additional VCSEL attributes and process elements. For example, the VCSEL arrays 101, 103 may use a laser transfer process. Laser-Induced Forward Transfer (LIFT) and pixel/repair trimming may be used to reduce the cost of constructing an RGB VCSEL array 101, 103.

To overcome the surface recombination on the chip sidewalls in micro-LED and micro-VCSEL, the contour of the chip may be implanted from top side through all epi layers remaining on the chip after laser transfer.

The blue and green GaN-based VCSEL structures may comprise dielectric DBR mirrors. The light generating section (active region) of the VCSEL may be grown by epitaxy. A wafer bonding process or wafer fusion may be used to combine the DBR stack with the active region. Fusion bonding refers to spontaneous adhesion of two planar substrates without the addition of any intermediate layer. As an alternative approach, DBRs of appropriate design may be placed individually for each emitter of each wavelength using a two-step laser transfer process, where the first step is DBR and the second step is for the active region. Because the dielectric DBR is an insulator, intracavity contacts are used to inject current into the active region.

Pulsed Laser Deposition (PLD) is the deposition of reflective layers and may be used for a resonant cavity LED. PLD is a thin-film deposition technique using high-energy laser pulses to vaporize the surface of a solid target inside a vacuum chamber. The vapor is then condensed on a substrate to form a thin film of up to a few micrometers in thickness. A thin film of a reflecting material can be used as a mirror in a blue or green LED. While the reflectivity may not be not high enough to use it in a VCSEL structure, it may be used in a Resonant Cavity (RC) LED. This can simplify and reduce the cost of the blue and green light source in some applications that utilize RC LEDs instead of VCSELs.

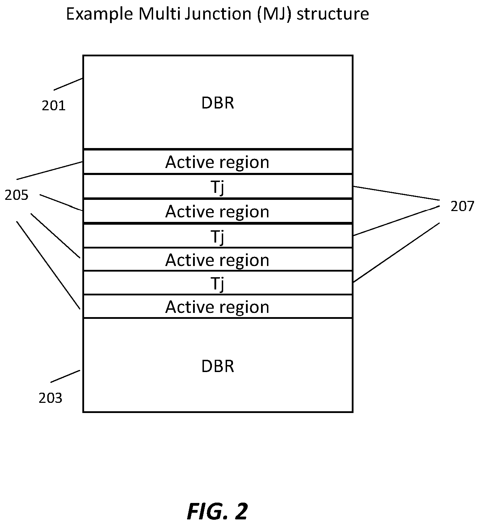

FIG. 2 illustrates an example embodiment of the disclosure comprising active regions 205 and tunnel junctions 207 between DBR mirror stacks 201 and 203, in accordance with various example implementations of this disclosure.

This multi-junction VCSEL technology implements multiple active regions 205 and tunnel junctions 207 between the two DBR mirror stacks 201 and 203. This enables higher efficiency VCSELs where multiple photons are emitted per a single electron. Adding additional active regions 205 and tunnel junctions 207 increases the power and slope efficiency and, at the same time, results in a higher voltage.

In the context of RGB VCSELs, the efficiency of blue color lasers is typically lower due to the material properties constraints. The blue laser efficiency can be improved by using this multi junction technology. The higher efficiency lasers (i.e., red) may use a standard single junction. This may allow the use of the same current supply with a comparable output power for the three RGB VCSELs.

Lithographically-defined apertures may provide an alternative to oxide apertures. The oxide-free VCSEL structures may use a lithographically-defined intra-cavity mesa for current and mode confinement. The confinement properties of such intra-cavity mesas are comparable to the oxide apertures, with a higher precision control of the aperture size.

In another version, the aperture may be controlled by a combination of a tunnel junction and a p-n junction. The p-n junction may be reverse biased thus blocking the current flow. The VCSEL aperture may be determined by the lateral dimension of the tunnel junction. By having the lithographic precision, the modal content of the devices may be accurately controlled in the production flow. For example, AR applications may use narrow linewidths that are produced via such precise modal control.

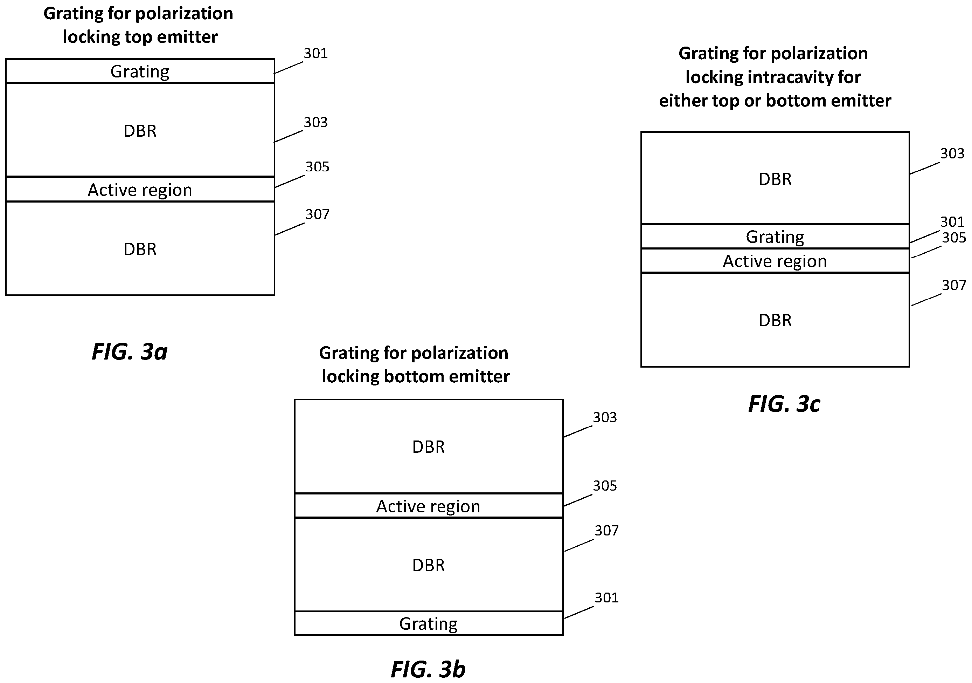

FIGs. 3a-c illustrate example embodiments of the disclosure comprising active regions 305 between DBR mirror stacks 303 and 307, in accordance with various example implementations of this disclosure. The optical properties of the layers in an AR glass may reach maximum efficiency for polarized light. In order to assure a single polarization for RGB emitting light sources, a grating layer 301 can be defined in the cap layer of the light emitting side. FIG. 3a shows how this solution can be used for top emitting devices. FIG. 3b shows how this solution can be used for bottom emitting devices. The gratings 301 can be lithographically defined. The pitch and the duty cycle can be optimized for a maximum polarization extinction ratio.

The solution in FIG. 3c can be used for either top or bottom emitting devices. The intra-cavity grating 301 in FIG. 3c also allows back-side emitting VCSELs with polarization locking and optics on the substrate (e.g., bottom emitting).

If additional optical functionality (e.g., a lens, a diffuser, etc.) is added to the emitting side of the VCSEL, the polarization lock can be implemented within the VCSEL cavity. The grating layer 301 is then etched inside of the cavity as shown in FIG. 3c. This structure can be realized by using wafer bonding or regrowth techniques.

Open-dirac electromagnetic cavities with linear dispersion may be realized by a truncated photonic crystal arranged in a hexagonal pattern. Such open-dirac electromagnetic cavities may exhibit unconventional scaling of losses in reciprocal space, leading to single-mode lasing that is maintained as the cavity is scaled up in size. VCSELs may be developed based on the principle of the open-Dirac electromagnetic cavities with linear dispersion. These VCSELs may be current injected and may work in the RGB range.

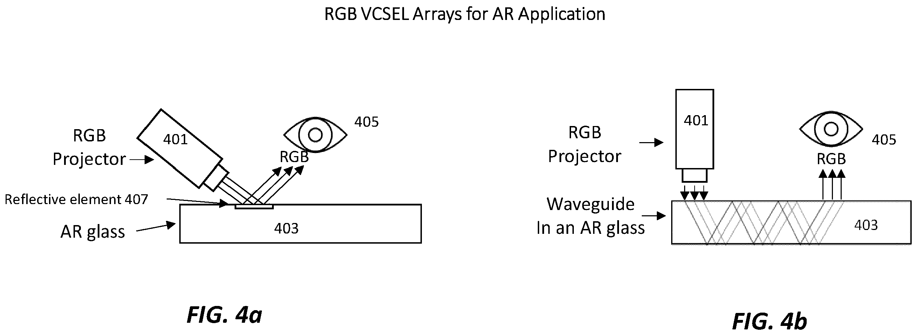

FIGs. 4a-b illustrate example embodiments of the disclosure comprising RGB VCSEL arrays for an AR application, in accordance with various example implementations of this disclosure. The ability to extend a single mode operation to larger apertures may be very advantageous for AR applications.

As shown in FIG. 4a, an RGB projector 401 may be aimed at a reflective element 407 on AR glass 403 before being viewed 405. As shown in FIG. 4b, an RGB projector 401 may also be aimed at a waveguide in an AR glass 403 before being viewed 405.

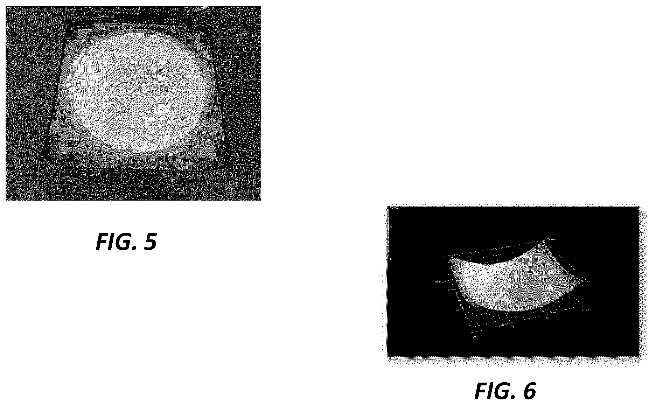

FIGs. 5 and 6 illustrate example embodiments of micro optics on a wafer, in accordance with various example implementations of this disclosure. Micro optics elements could be integrated on top of VCSEL emitters using a wafer level process based on nano imprint lithography (NIL) of a polymer layer dispensed over the VCSEL wafer. Using NIL processes, micro optics elements with high conformance accuracy may be generated with positional accuracy of <1um. The NIL technology provides the flexibility to produce a variety of micro lenses with different designs, forms and shapes.

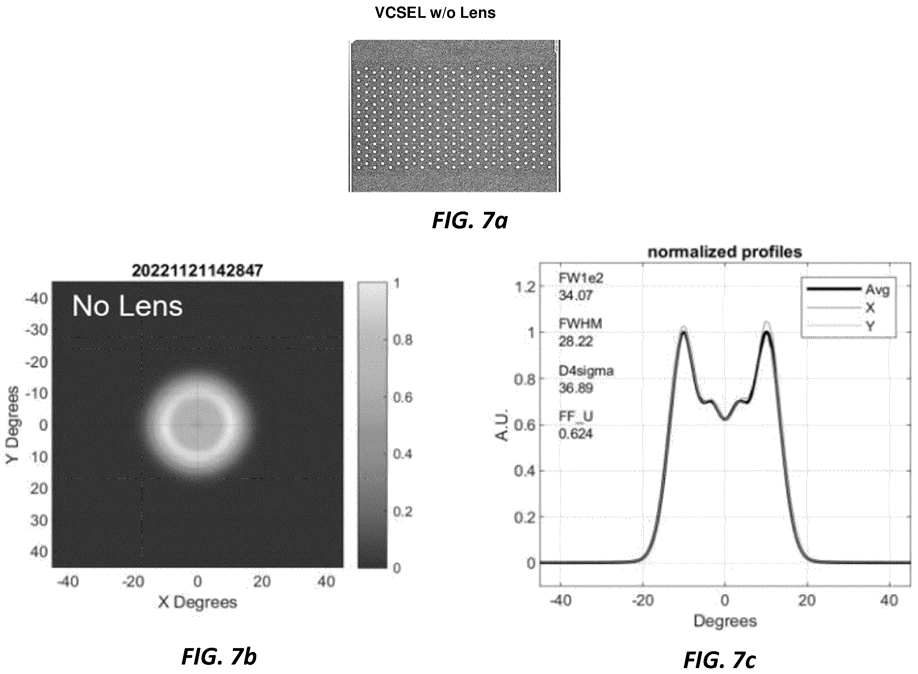

FIGs. 7a-c illustrates an example embodiment of the disclosure comprising a VCSEL without a lens, in accordance with various example implementations of this disclosure. FIG. 7a shows the physical VCSEL. FIG. 7b shows the far field of this VCSEL without a lens. FIG. 7c shows that the far field of the VCSEL without a lens is around 30°.

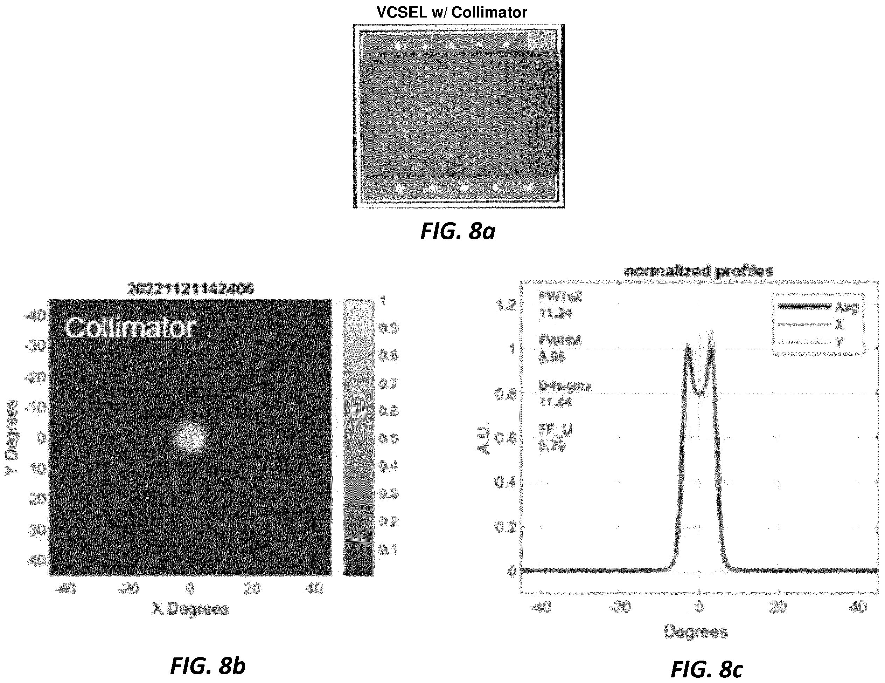

Two examples of micro optics elements are a collimator and a diffuser. FIGs. 8a-c illustrates an example embodiment of the disclosure comprising a VCSEL with a collimator, in accordance with various example implementations of this disclosure. FIG. 8a shows the physical VCSEL with the collimator. FIG. 8b shows the far field of this VCSEL with the collimator. FIG. 8c shows that this collimator can collimate the far field of the VCSEL (from around 30° as shown in FIG. 7c) to below 10°.

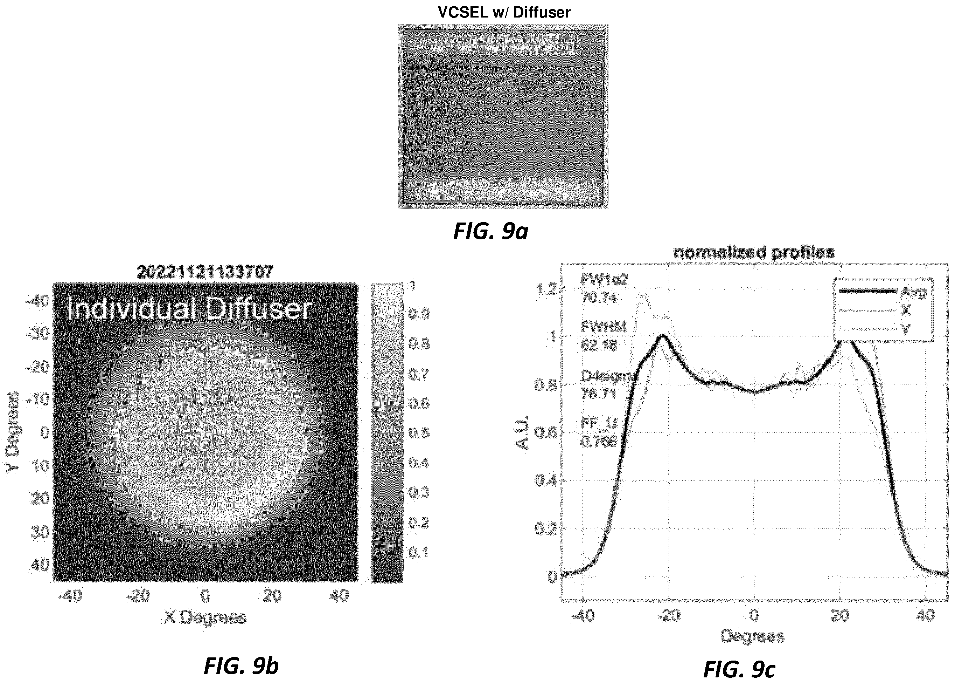

FIGs. 9a-c illustrates an example embodiment of the disclosure comprising a VCSEL with a diffuser, in accordance with various example implementations of this disclosure. FIG. 9a shows the physical VCSEL with the diffuser. FIG. 9b shows the far field of this VCSEL with the diffuser. FIG. 9c shows that this diffuser can expand the far field of the VCSEL (from around 30° as shown in FIG. 7c) to over 65°.

The present method and/or system may be realized in hardware, software, or a combination of hardware and software. The present methods and/or systems may be realized in a centralized fashion in at least one computing system, or in a distributed fashion where different elements are spread across several interconnected computing systems. Any kind of computing system or other apparatus adapted for carrying out the methods described herein is suited. A typical implementation may comprise one or more application specific integrated circuit (ASIC), one or more field programmable gate array (FPGA), and/or one or more processor (e.g., x86, x64, ARM, PIC, and/or any other suitable processor architecture) and associated supporting circuitry (e.g., storage, DRAM, FLASH, bus interface circuits, etc.). Each discrete ASIC, FPGA, Processor, or other circuit may be referred to as "chip," and multiple such circuits may be referred to as a "chipset." Another implementation may comprise a non-transitory machine-readable (e.g., computer readable) medium (e.g., FLASH drive, optical disk, magnetic storage disk, or the like) having stored thereon one or more lines of code that, when executed by a machine, cause the machine to perform processes as described in this disclosure. Another implementation may comprise a non-transitory machine-readable (e.g., computer readable) medium (e.g., FLASH drive, optical disk, magnetic storage disk, or the like) having stored thereon one or more lines of code that, when executed by a machine, cause the machine to be configured (e.g., to load software and/or firmware into its circuits) to operate as a system described in this disclosure.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A system, the system comprising:
an array of vertical-cavity surface-emitting lasers, VCSELs, wherein:
the array of VCSELs comprises:
at least one VCSEL operable to emit in a blue wavelength range,
at least one VCSEL operable to emit in a green wavelength range, and
at least one VCSEL operable to emit in a red wavelength range; and
each VCSEL in the array of VCSELs comprises:
an active region, and
two distributed Bragg reflector, DBR, mirror stacks (201, 203), **characterized in that**
the at least one VCSEL that is operable to emit in the blue wavelength range comprises a plurality of active regions (205) between the two DBR mirror stacks, and
the at least one VCSEL that is operable to emit in the red wavelength range comprises a single active region between the two DBR mirror stacks.

2. The system of claim 1, wherein the blue wavelength range is 440 to 495 nm, the green wavelength range is 495 to 580 nm and the red wavelength range is 610 to 760 nm.

3. The system of claim 1, wherein the array of VCSELs is a one-dimensional array.

4. The system of claim 1, wherein the array of VCSELs is a two-dimensional array.

5. The system of claim 1, wherein the at least one VCSEL operable to emit in the blue wavelength range is GaN-based and comprises an InGaN active region.

6. The system of claim 1, wherein the at least one VCSEL operable to emit in the green wavelength range is GaN-based and comprises an InGaN active region.

7. The system of claim 1, wherein the at least one VCSEL operable to emit in the red wavelength range comprises an AlGalnP active region and AlGaAs N and P DBR mirror stacks grown on a GaAs substrate.

8. The system of claim 1, wherein each active region, of the plurality of active regions, is separated from each other active region, of the plurality of active regions, by a tunnel junction.

9. The system of claim 1, wherein the at least one VCSEL that is operable to emit in the blue wavelength range and the at least one VCSEL that is operable to emit in the red wavelength range are operably powered by a common current supply.

10. The system of claim 1, wherein each VCSEL of the array of VCSELs comprises a grating in a cap layer of a light emitting side.

11. The system of claim 1, wherein each VCSEL of the array of VCSELs comprises a grating adjacent to an active region.

12. The system of claim 11, wherein the grating is etched inside of a cavity.

13. The system of claim 1, wherein each VCSEL of the array of VCSELs comprises an open-Dirac electromagnetic cavity with linear dispersion.

14. The system of claim 1, wherein each VCSEL of the array of VCSELs comprises a micro lens.

15. The system of claim 14, wherein the micro lens is a collimator.

16. The system of claim 14, wherein the micro lens is a diffuser.

17. The system of claim 14, wherein the micro lens is integrated on top of each VCSEL via nano imprint lithography of a polymer layer.

## Patentansprüche

1. Ein System umfassend:
ein Array von vertical-cavity surface-emitting Lasern, VCSELn, wobei:
das Array von VCSELn umfasst:
mindestens einen VCSEL, der betreibbar ist, um in einem blauen Wellenlängenbereich zu emittieren,
mindestens einen VCSEL, der betreibbar ist, um in einem grünen Wellenlängenbereich zu emittieren, und
mindestens einen VCSEL, der betreibbar ist, um in einem roten Wellenlängenbereich zu emittieren; und
jeder VCSEL in dem Array von VCSELn umfasst:
einen aktiven Bereich, und
zwei verteilte Bragg-Reflektor, DBR, Spiegelstapel (201, 203), **dadurch gekennzeichnet, dass** der mindestens eine VCSEL, der betreibbar ist, um in dem blauen Wellenlängenbereich zu emittieren, eine Mehrzahl von aktiven Bereichen (205) zwischen den zwei DBR-Spiegelstapeln umfasst, und
der mindestens eine VCSEL, der betreibbar ist, um in dem roten Wellenlängenbereich zu emittieren, einen einzigen aktiven Bereich zwischen den zwei DBR-Spiegelstapeln umfasst.

2. System nach Anspruch 1, wobei der blaue Wellenlängenbereich 440 bis 495 nm beträgt, der grüne Wellenlängenbereich 495 bis 580 nm beträgt und der rote Wellenlängenbereich 610 bis 760 nm beträgt.

3. System nach Anspruch 1, wobei das Array von VCSELn ein eindimensionales Array ist.

4. System nach Anspruch 1, wobei das Array von VCSELn ein zweidimensionales Array ist.

5. System nach Anspruch 1, wobei der mindestens eine VCSEL, der betreibbar ist, um in dem blauen Wellenlängenbereich zu emittieren, GaN-basiert ist und einen aktiven InGaN-Bereich umfasst.

6. System nach Anspruch 1, wobei der mindestens eine VCSEL, der betreibbar ist, um in dem grünen Wellenlängenbereich zu emittieren, GaN-basiert ist und einen aktiven InGaN-Bereich umfasst.

7. System nach Anspruch 1, wobei der mindestens eine VCSEL, der betreibbar ist, um in dem roten Wellenlängenbereich zu emittieren, einen aktiven AlGalnP-Bereich und AlGaAs-N- und P-DBR-Spiegelstapel umfasst, die auf einem GaAs-Substrat aufgewachsen sind.

8. System nach Anspruch 1, wobei jeder aktive Bereich der Mehrzahl von aktiven Bereichen durch einen Tunnelübergang von jedem anderen aktiven Bereich der Mehrzahl von aktiven Bereichen getrennt ist.

9. System nach Anspruch 1, wobei der mindestens eine VCSEL, der betreibbar ist, um in dem blauen Wellenlängenbereich zu emittieren, und der mindestens eine VCSEL, der betreibbar ist, um in dem roten Wellenlängenbereich zu emittieren, durch eine gemeinsame Stromversorgung operativ gespeist werden.

10. System nach Anspruch 1, wobei jeder VCSEL des Arrays von VCSELn ein Gitter in einer Deckschicht einer lichtemittierenden Seite umfasst.

11. System nach Anspruch 1, wobei jeder VCSEL des Arrays von VCSELn ein Gitter angrenzend an einen aktiven Bereich umfasst.

12. System nach Anspruch 11, wobei das Gitter innerhalb einer Kavität geätzt ist.

13. System nach Anspruch 1, wobei jeder VCSEL des Arrays von VCSELn eine offene Dirac-elektromagnetische-Kavität mit linearer Dispersion umfasst.

14. System nach Anspruch 1, wobei jeder VCSEL des Arrays von VCSELn eine Mikrolinse umfasst.

15. System nach Anspruch 14, wobei die Mikrolinse ein Kollimator ist.

16. System nach Anspruch 14, wobei die Mikrolinse ein Diffusor ist.

17. System nach Anspruch 14, wobei die Mikrolinse über Nanoimprint-Lithographie einer Polymerschicht auf jedem VCSEL integriert ist.

## Revendications

1. Système comprenant :
une matrice de lasers à cavité verticale émettant par la surface, VCSEL, dans laquelle :
la matrice de lasers VCSEL comprend :
au moins un laser VCSEL apte à émettre dans une plage de longueurs d'onde bleues,
au moins un laser VCSEL apte à émettre dans une plage de longueurs d'onde vertes, et
au moins un laser VCSEL apte à émettre dans une plage de longueurs d'onde rouges ; et
chaque laser VCSEL de la matrice de lasers VCSEL comprend :
une région active, et
deux piles de miroirs formant réflecteur de Bragg distribué, DBR, (201, 203), **caractérisé en ce que** :
ledit au moins un laser VCSEL qui est apte à émettre dans la plage de longueurs d'onde bleues comprend une pluralité de régions actives (205) entre les deux piles de miroirs DBR, et
ledit au moins un laser VCSEL qui est apte à émettre dans la plage de longueurs d'onde rouges comprend une seule région active entre les deux piles de miroirs DBR.

2. Système selon la revendication 1, dans lequel la plage de longueurs d'onde bleues va de 440 à 495 nm, la plage de longueurs d'onde vertes va de 495 à 580 nm et la plage de longueurs d'onde rouges va de 610 à 760 nm.

3. Système selon la revendication 1, dans lequel la matrice de lasers VCSEL est une matrice à une dimension.

4. Système selon la revendication 1, dans lequel la matrice de lasers VCSEL est une matrice à deux dimensions.

5. Système selon la revendication 1, dans lequel ledit au moins un laser VCSEL apte à émettre dans la plage de longueurs d'onde bleues est à base de GaN et comprend une région active en InGaN.

6. Système selon la revendication 1, dans lequel ledit au moins un laser VCSEL apte à émettre dans la plage de longueurs d'onde vertes est à base de GaN et comprend une région active en InGaN.

7. Système selon la revendication 1, dans lequel ledit au moins un laser VCSEL apte à émettre dans la plage de longueurs d'onde rouges comprend une région active en AlGaInP et des piles de miroirs DBR en AlGaAs N et P que l'on a fait croître sur un substrat de GaAs.

8. Système selon la revendication 1, dans lequel chaque région active de la pluralité de régions actives est séparée de chaque autre région active de la pluralité de régions actives par une jonction à effet tunnel.

9. Système selon la revendication 1, dans lequel ledit au moins un laser VCSEL qui est apte à émettre dans la plage de longueurs d'onde bleues et ledit au moins un laser VCSEL qui est apte à émettre dans la plage de longueurs d'onde rouges sont alimentés fonctionnellement par une alimentation électrique commune.

10. Système selon la revendication 1, dans lequel chaque laser VCSEL de la matrice de lasers VCSEL comprend un réseau dans une couche supérieure d'un côté émetteur de lumière.

11. Système selon la revendication 1, dans lequel chaque laser VCSEL de la matrice de lasers VCSEL comprend un réseau adjacent à une région active.

12. Système selon la revendication 11, dans lequel le réseau est gravé à l'intérieur d'une cavité.

13. Système selon la revendication 1, dans lequel chaque laser VCSEL de la matrice de lasers VCSEL comprend une cavité électromagnétique de Dirac ouverte à dispersion linéaire.

14. Système selon la revendication 1, dans lequel chaque laser VCSEL de la matrice de lasers VCSEL comprend une microlentille.

15. Système selon la revendication 14, dans lequel la microlentille est un collimateur.

16. Système selon la revendication 14, dans lequel la microlentille est un diffuseur.

17. Système selon la revendication 14, dans lequel la microlentille est intégrée sur le dessus de chaque laser VCSEL par lithographie à nanoimpression d'une couche de polymère.
